# EUROPEAN PATENT APPLICATION

(11) **EP 4 797 475 A1**
(43) Date of publication of application: **26.08.2026**
(21) Application number: 26158238.1
(22) Date of filing: 12.02.2026
(51) Int. Cl.: H02H 9/00, H02H 9/04, H10D 8/20, H10D 8/80, H10D 88/00, H10D 89/60, H10W 42/60, H10W 90/20

(54) **BI-DIRECTIONAL ASYMMETRIC TRANSIENT VOLTAGE SUPPRESSOR**

(30) Priority: 20.02.2025 CN 202510193425
(71) Applicant: Littelfuse Semiconductor (Wuxi) Co., Ltd., Wuxi, Jiangsu 214142 (CN)
(72) Inventor: Zhou, Jifeng, Wuxi, 214142 (CN); Gu, Xingchong, Wuxi, 214142 (CN)
(74) Representative: Arnold & Siedsma

(57) **Abstract**

A transient voltage suppression system, device, apparatus, structure and associated methods thereof. The system includes a first voltage suppression device having a first voltage suppression device substrate, a first voltage suppression device first layer, and a first voltage suppression device second layer. The first voltage suppression device substrate is coupled to the first voltage suppression device first layer and is coupled to the first voltage suppression device second layer. The system includes a second voltage suppression device having a second voltage suppression device substrate, a second voltage suppression device first layer and a second voltage suppression device second layer. The second voltage suppression device substrate is coupled to the second voltage suppression device first layer and is coupled to the second voltage suppression device second layer. The first voltage suppression device is coupled to the second voltage suppression device.

## Description

### TECHNICAL FIELD

This disclosure relates generally to the field of power semiconductor discrete devices, and in particular, to bidirectional asymmetric transient voltage suppressor devices.

### BACKGROUND

A discrete semiconductor is a device specified to perform an elementary electronic function and is not divisible into separate components functional in themselves. Power semiconductors are used as switches or rectifiers in power electronics. Diodes, transistors, thyristors, and rectifiers are examples of discrete power semiconductors. Discrete power semiconductors are found in a variety of different environments, from very low power systems up to very high-power systems.

Asymmetric bidirectional transient voltage suppression (TVS) devices are designed to protect sensitive electronic components from voltage spikes by clamping overvoltage transients. Unlike symmetric TVS devices, which have identical clamping voltages in both directions, asymmetric bidirectional TVS devices have different clamping voltages for positive and negative transients. By integrating two separate TVS diodes into a single component, these devices help reduce parasitic effects and save PCB space, enhancing the reliability and efficiency of high-speed switching applications. However, existing TVS devices are not capable of providing variations of breakdown voltages across the devices.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The disclosure relates to a transient voltage suppression system. The system may include a first voltage suppression device having a first voltage suppression device substrate, a first voltage suppression device first layer, and a first voltage suppression device second layer. The first voltage suppression device substrate may be coupled to the first voltage suppression device first layer, and may be coupled to the first voltage suppression device second layer. The system may include a second voltage suppression device having a second voltage suppression device substrate, a second voltage suppression device first layer and a second voltage suppression device second layer. The second voltage suppression device substrate may be coupled to the second voltage suppression device first layer and may be coupled to the second voltage suppression device second layer. The first voltage suppression device may be coupled to the second voltage suppression device.

The disclosure may include one or more of the following optional features. The first voltage suppression device substrate and the second voltage suppression device substrate may be at least one of: a N-type substrate or a P-type substrate. The first voltage suppression device first layer and the second voltage suppression device first layer may be at least one of: a N-type layer or a P-type layer. The first voltage suppression device second base layer and the second voltage suppression device second layer may be at least one of: a N-type layer, a P-type layer, a N+-type layer, or a P+-type layer.

The first voltage suppression device first layer may be a P-type layer. The first voltage suppression device substrate may be a N-type substrate. The first voltage suppression device second layer may be a N+-type layer. The first voltage suppression device first layer may be a N-type layer. The first voltage suppression device substrate may be a P-type substrate, and the first voltage suppression device second layer may be a P+-type layer.

The second voltage suppression device first layer may be a N+-type layer. The second voltage suppression device substrate may be a N-type substrate, and the second voltage suppression device second layer may be a P-type layer.

The second voltage suppression device first layer may be a P+-type layer, the second voltage suppression device substrate may be a P-type substrate, and the second voltage suppression device second layer may be a N-type layer.

The second voltage suppression device first layer may be a P-type layer, the second voltage suppression device substrate may be a N-type substrate, and the second voltage suppression device second layer may be a P-type layer.

The second voltage suppression device first layer may be a N-type layer, the second voltage suppression device substrate may be a P-type substrate, and the second voltage suppression device second layer may be a N-type layer.

The system may include one or more terminals coupled to one or more of the first and second layers of the first and second voltage suppression devices. The transient voltage suppression device may be characterized by a clamping voltage. The clamping voltage may be determined based on biasing of the one or more terminals.

Each of the first and second voltage suppression devices may be characterized by a respective breakdown voltage.

The first voltage suppression device may be at least one of: a unidirectional transient voltage suppression device or a bidirectional transient voltage suppression device. The second voltage suppression device may be at least one of: a unidirectional transient voltage suppression device or a bidirectional transient voltage suppression device. The transient voltage suppression system may be an asymmetric transient voltage suppression system.

The first voltage suppression device may be coupled to the second voltage suppression device using a conductive solder. The conductive solder may couple the second layer of the first voltage suppression device and the first layer of the second voltage suppression device.

The first voltage suppression device first layer may be coupled to an anode or a cathode termination layer, and the second voltage suppression device second layer may be coupled to another anode or another cathode termination layer.

The current subject matter relates to a method for manufacturing a semiconductor device. The method may include providing a first voltage suppression device having a first voltage suppression device substrate, a first voltage suppression device first layer, and a first voltage suppression device second layer, the first voltage suppression device substrate coupled to the first voltage suppression device first layer, and coupled to the first voltage suppression device second layer; providing a second voltage suppression device having a second voltage suppression device substrate, a second voltage suppression device first layer and a second voltage suppression device second layer, the second voltage suppression device substrate being coupled to the second voltage suppression device first layer and being coupled to the second voltage suppression device second layer; and coupling the first voltage suppression device to the second voltage suppression device.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain the principles associated with the disclosure. In the drawings,
FIG. 1a illustrates an example of a transient voltage suppressor (TVS) device;
FIG. 1b illustrates an example current-voltage plot showing clamping voltage and breakdown voltage of the TVS device shown in FIG. 1a;
FIG. 2a illustrates an exemplary bidirectional asymmetric TVS device, according to the current subject matter;
FIG. 2b illustrates an example of current-voltage plot for the device shown in FIG. 2a, according to the current subject matter;
FIGS. 3a-3b illustrate examples of bidirectional semiconductor devices that include two TVS devices, according to the current subject matter;
FIGS. 4a-4d illustrate further examples of bidirectional semiconductor devices that include two TVS devices with various type of substrates and base layers, according to the current subject matter; and
FIG. 5 illustrates an exemplary process, according to the current subject matter.

The drawings are not necessarily to scale. The drawings are merely representations, not intended to portray specific parameters of the disclosure. The drawings are intended to depict the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings.

To address these and potentially other deficiencies of currently available solutions, the current subject matter relates to a method, system, articles of manufacture, and the like that can, among other possible advantages, provide a bidirectional asymmetric transient voltage suppressor (TVS) device.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by fast rise times and high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 70 volts in electrical cables. In a cloud-to-ground strike, the voltage transient generating effect is significantly greater.

Transient voltage suppression (TVS) diodes are electronic components designed to protect sensitive electronics from high voltage transients. TVS diodes can respond to overvoltage events faster than most other types of circuit protection devices and are available in a variety of surface mount and through-hole circuit board mounting formats. TVS diodes are generally used to protect against electrical overstress such as those induced by lightning strikes, inductive load switching, and ESD associated with transmission on data lines and electronic circuits.

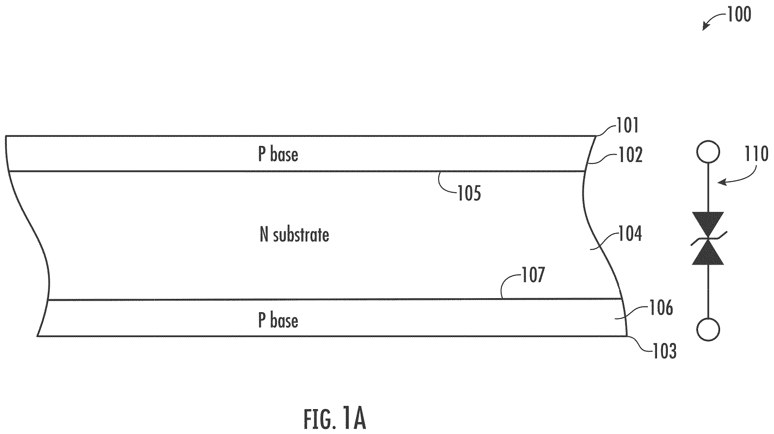

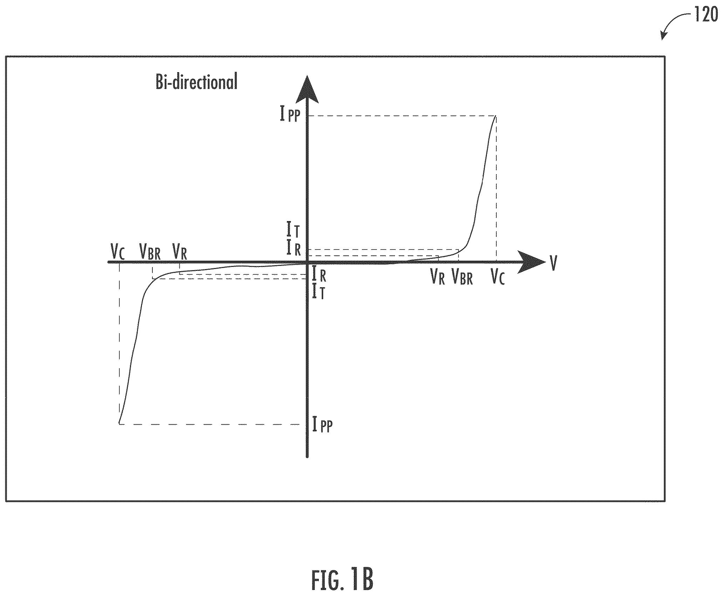

FIG. 1a illustrates an example of a bidirectional symmetric transient voltage suppressor (TVS) device 100 (along with a corresponding polarity schematic 110). The TVS device 100 can be formed in a semiconductor substrate, such as silicon. In particular, the TVS device 100 can include a substrate 104, a first base layer 102, and a second base layer 106. The substrate 104 can be formed having a polarity of a first type. The substrate 104 can be formed between the first base layer 102 and the second base layer 106. The first and second base layers 102, 106 can be formed having polarities of a second type. The second type polarity may be opposite to the first type polarity. As shown in FIG. 1, the substrate 104 can be an N-type substrate. The first and second base layers 102 and 106 can be P-type base layers. Further, the first base layer 102 can form a P-N junction 105 with the substrate 104. The second base layer 106 can form P-N junction 107 with the substrate 104.

As can be understood, while FIG. 1 illustrates the device 100 being based upon a N-type substrate, the TVS device 100 can have a P-type substrate with N-type first and second base layers disposed on opposite surfaces. The TVS device 100 may be a bidirectional symmetric device, however, as can be understood, the TVS 100 may be any other type of device.

Further, the TVS device 100 can also include terminals 101 and 103 for connection of the TVS device 100 to various circuit components (e.g., printed circuit board, etc.). The first terminal 101 may be referred to as an anode terminal. The anode terminal 101 may be formed above the first base layer 101. The second terminal 103 may be referred to as a cathode terminal. The cathode terminal 103 may be formed below the second base layer 106. As can be understood, the designations of "above" and "below" are meant for illustrative purposes only and are intended to limit the current subject matter. The first and second terminals 101, 103 may be manufactured from any conductive material, such as, for example, but not limited to, copper, copper alloy, silver, metallic alloys, etc., and/or any combinations thereof.

FIG. 1b illustrates an example current-voltage plot 120 showing clamping voltage (*V_{cl}*) and breakdown voltage (*V_{BR}*) of the TVS device 100 shown in FIG. 1a. The device's breakdown voltage (*V_{BR}*) of the symmetric TVS device 100 is between its clamping voltage (*V_{cl}*) and reverse standoff voltage (*V_{R}*)*.*

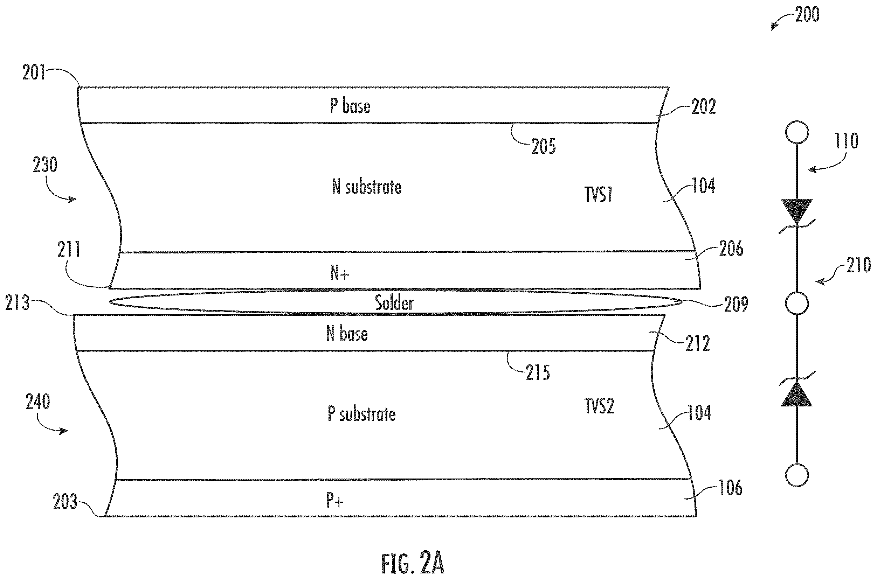

FIG. 2a illustrates an exemplary bidirectional asymmetric TVS device 200, according to the current subject matter. Similar to the device 100 shown in FIG. 1a, the TVS device 200 may be configured to be formed in a semiconductor substrate, such as, for example, silicon. As can be understood, other substrate materials may be used. However, the device 200 may be configured to provide an advantageous structure that may accommodate different breakdown voltages. In particular, the TVS device 200 may include two or more stacked TVS devices joined together using solder and/or any other binding material. This may be helpful in improving performance of the TVS device, which may be useful in various industries, such as, for example, automotive applications.

As stated herein, the TVS 200 may be configured to include a combination of devices. It may include a first TVS device 230 ("TVS1") and a second TVS device 240 ("TVS2") that may be coupled to the TVS device 230 using solder 209 and/or any other binding method. A polarity diagram 210 is illustrated to next to the TVS device 200 showing polarity of each device 230, 240 using black triangles.

The TVS device 230 may include a substrate 204, a base layer 202, and an enhancement layer 206. The substrate 204 may have a polarity of a first type, e.g., N-type. The substrate 204 may be formed between the base layer 202 and the enhancement layer 206. The base layer 202 may have a polarity of a second type, e.g., P-type. The enhancement layer 206 may have a polarity of a third type, e.g., N+-type. The base layer 202 may form a P-N junction 205 with the substrate 204. The device 230, while shown in FIG. 2a as being based upon a N-type substrate, may have a P-type substrate with N-type first base/enhancement layers disposed on opposite surfaces (as discussed herein). The TVS device 230 may be a unidirectional device, a bidirectional device, and/or any other type of device.

Further, the TVS device 230 may also include terminal layers 201 and 211. The first terminal layer 201 may be formed above and coupled to the base layer 202. It may also be coupled to an anode and/or cathode terminal of the device 200. The second terminal layer 211 may be formed below the enhancement layer 206. As can be understood, the designations of "above" and "below" are meant for illustrative purposes only and are intended to limit the current subject matter. The first and second terminal layers 201 and 211 may be manufactured from a conductive material, such as, for example, but not limited to, copper, copper alloy, silver, metallic alloys, etc., and/or any combinations thereof.

The TVS device 240 may include a substrate 214, a base layer 212 and an enhancement layer 216. The substrate 214 may have a polarity of the second type, e.g., P-type. The substrate 214 may be formed between the base layer 212 and the enhancement layer 216. The base layer 212 may have a polarity of the first type, e.g., N-type. The enhancement layer 216 may have a polarity of a fourth type, e.g., P+-type. The TVS device 240, while shown being based upon a P-type substrate, may have a N-type substrate with corresponding first base/enhancement layers disposed on opposite surfaces (as discussed herein). The base layer 212 may form a P-N junction 215 with the substrate 214. The TVS device 240 may be a unidirectional device, a bidirectional device, and/or any other type of device.

The TVS device 240 may also include terminal layers 203 and 213. The first terminal layer 213 may be formed above and coupled to the first base layer 212. The second terminal layer 203 may be formed below the enhancement layer 216 and may also be coupled to an anode and/or cathode terminal of the device 200.

Moreover, as stated herein, the terminal layers 201, 203 may be manufactured from a conductive material, such as, for example, but not limited to, copper, copper alloy, silver, metallic alloys, etc., and/or any combinations thereof. The terminals to which the terminal layers 201 and 203 may be coupled, respectively, may be used for coupling the device 200 to one or more electronic components (e.g., printed circuit board, etc.).

The solder 209 may be used to couple the TVS devices 230 and 240 to form the semiconductor device 200. The solder may be a conductive solder and thereby, allow conductivity of current between TVS devices 230 and 240. The solder 209 may be manufactured from any desired conductive material, such as, for example, but not limited to, copper, copper alloy, silver, metallic alloys, etc., and/or any combinations thereof.

To achieve polarity of the layers 202-206, 212-216, each layer may be doped using one or more dopant materials. The dopant materials may include, for example, phosphorous, boron, arsenic, gallium, and/or any other desired materials. Each layer 202-206, 212-216 may be formed using the same dopant materials and/or different dopant materials.

Moreover, the dopant materials concentration in the layer(s) 202-206, 212-216 may be uniform and/or non-uniform. This may allow for varying characteristics of the TVS device 200. Each layer(s) 202-206, 212-216 may also have its own predetermined thickness. The thicknesses of the layer(s) 202 and 206 may be less than the thickness of the substrate 204. Similarly, the thicknesses of the layer(s) 212 and 216 may be less than the thickness of the substrate 214. As can be understood, any other types of doping and/or any other thicknesses of layer(s) 202-206, 212-216 (and/or any other components of the TVS device 200) are possible.

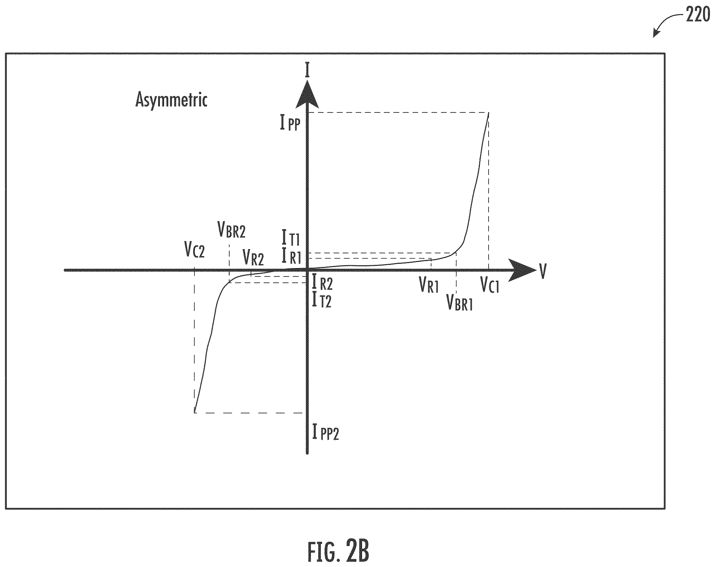

The arrangement of the TVS devices 230 and 240 within the semiconductor device 200 may be configured to define specific clamping voltages (*V_{C1}, V_{C2}* corresponding to clamping voltages of devices 230, 240, respectively) and breakdown voltages (*V_{BR1}, V_{BR2}* corresponding to devices 230, 240, respectively) of the TVS device 200, as shown by the plot 220 in FIG. 2b. Each TVS device's 230, 240 breakdown voltages (*V_{BR1}, V_{BR2}*) of the asymmetric bidirectional TVS device 200 are between their respective clamping voltages (*V_{C1}, V_{C2}*) and their respective reverse standoff voltages (*V_{R1}, V_{R2}*)*,* where each has a different voltage rating, thereby allowing the TVS device 200 to be a bidirectional device.

During operation, the TVS devices 230 and 240 may be configured to clamp voltage from different directions. For example, the TVS device 230 may be configured to clamp voltage when terminal 203 is forward biased with respect to terminal 201. The TVS device 240 may be configured to clamp voltage when terminal 201 is forward biased with respect to terminal 203. This may allow for bidirectional asymmetric nature of the semiconductor device 200.

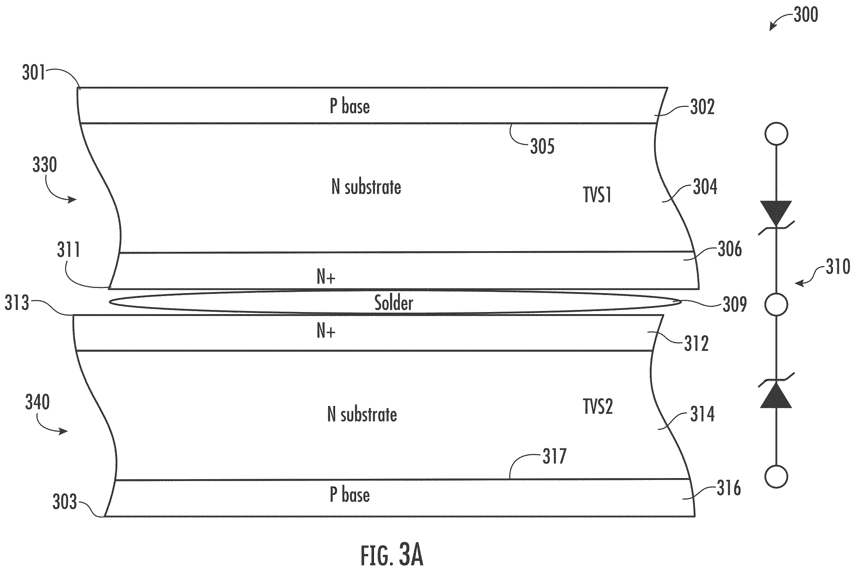

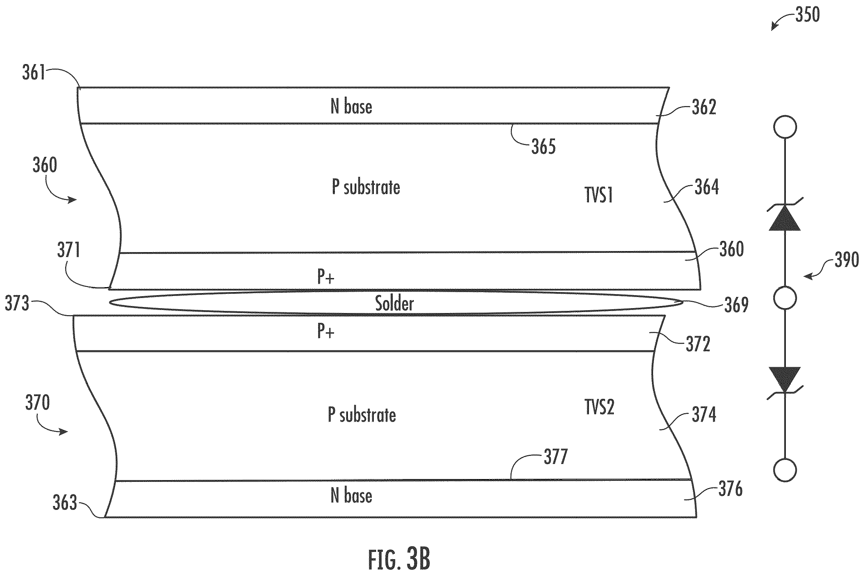

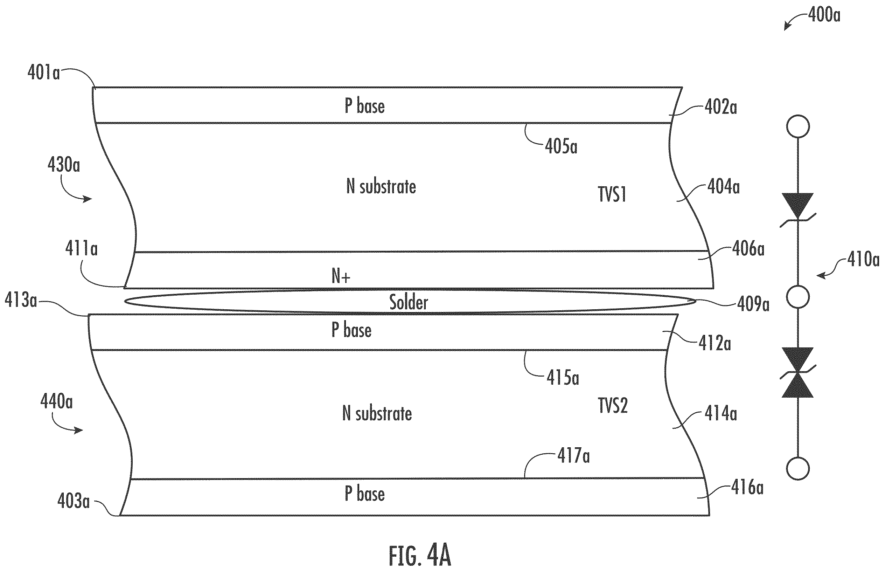

FIGS. 3a-3b illustrate examples of bidirectional semiconductor devices that include two unidirectional TVS devices with same type of substrates, e.g., FIG. 3a shows TVS devices with N-type substrates and FIG. 3b shows TVS devices with P-type substrates. FIGS. 4a-4d illustrate further examples of bidirectional semiconductor devices that include one unidirectional TVS and one bidirectional TVS devices with various type of substrates and base layers.

FIG. 3a illustrates an exemplary bidirectional asymmetric TVS device 300, according to the current subject matter. The TVS device 300 may be configured to be formed in a semiconductor substrate, such as, for example, silicon. As can be understood, other substrate materials may be used. The TVS device 300 may include a first TVS device 330 ("TVS1") and a second TVS device 340 ("TVS2") that may be coupled to the TVS device 330 using solder 309 and/or any other binding material/method. A polarity diagram 310 is illustrated to next to the TVS device 300 showing polarity of each device 330, 340 using black triangles. Each TVS device 330, 340 may have its own breakdown voltage.

The TVS device 330 may include a substrate 304, a base layer 302, and an enhancement layer 306. The substrate 304 may have a polarity of the first type, e.g., N-type. The substrate 304 may be formed between the base layer 302 and the enhancement layer 306. The base layer 302 may have a polarity of the second type, e.g., P-type. The enhancement layer 306 may have a polarity of the third type, e.g., N+-type. The base layer 302 may form a P-N junction 305 with the substrate 304. The TVS device 330 may be a unidirectional device.

The TVS device 330 may also include terminal layers 301 and 311. The first terminal layer 311 may be formed above and coupled to the base layer 302. It may also be coupled to an anode and/or a cathode terminal of the device 300. The second terminal layer 311 may be formed below the enhancement layer 306. The first and second terminal layers 301 and 311 may be manufactured from a conductive material, such as, for example, but not limited to, copper, copper alloy, silver, metallic alloys, etc., and/or any combinations thereof.

The TVS device 340 may include a substrate 314, an enhancement layer 312 and a base layer 316. The substrate 314 may have a polarity of the first type, e.g., N-type, which may be the same as the polarity of the substrate 304 of the TVS device 330. The substrate 314 may be formed between the enhancement layer 312 and the base layer 316. The enhancement layer 312 may have a polarity of the third type, e.g., N+-type. The base layer 316 may have a polarity of the second type, e.g., P-type. The base layer 316 may form a P-N junction 317 with the substrate 314.The TVS device 340 may be a unidirectional device. The TVS device 340 may also include terminal layers 303 and 313. The first terminal layer 313 may be formed above and coupled to the enhancement layer 312. The second terminal layer 303 may be formed below the base layer 316 and may also be coupled to an anode and/or a cathode terminal of the device 300.

Moreover, as stated herein, the second terminal layers 301, 303 may be manufactured from a conductive material, such as, for example, but not limited to, copper, copper alloy, silver, metallic alloys, etc., and/or any combinations thereof. The terminals to which the terminal layers 301 and 303 may be coupled, respectively, may be used for coupling the device 300 to one or more electronic components (e.g., printed circuit board, etc.).

The solder 309 may be used to couple the TVS devices 330 and 340 to form the semiconductor device 300. The solder may be a conductive solder and thereby, allow conductivity of current between TVS devices 330 and 340. The solder 309 may be manufactured from any desired conductive material, such as, for example, but not limited to, copper, copper alloy, silver, metallic alloys, etc., and/or any combinations thereof.

The dopant materials concentration in the layer(s) 302-306, 312-316 may be uniform and/or non-uniform, which may allow for varying characteristics of the TVS device 300. Each layer(s) 302-306, 312-316 may also have its own predetermined thickness. The thicknesses of the layer(s) 302 and 306 may be less than the thickness of the substrate 304 and the thicknesses of the layer(s) 312 and 316 may be less than the thickness of the substrate 314. As can be understood, any other types of doping and/or any other thicknesses of layer(s) 302-306, 312-316 (and/or any other components of the TVS device 300) are possible.

During operation, the TVS devices 330 and 340 may be configured to clamp voltage from different directions. For example, the TVS device 330 may be configured to clamp voltage when terminal 303 is forward biased with respect to terminal 301. The TVS device 340 may be configured to clamp voltage when terminal 301 is forward biased with respect to terminal 303. This may allow for bidirectional asymmetric nature of the semiconductor device 300.

FIG. 3b illustrates another exemplary bidirectional asymmetric TVS device 350, according to the current subject matter. The TVS device 350 may include a first TVS device 360 ("TVS1") and a second TVS device 370 ("TVS2") that may be coupled to the TVS device 360 using solder 369 and/or any other binding material/method. A polarity diagram 390 is illustrated to next to the TVS device 350 showing polarity of each device 360, 370 using black triangles. Each TVS device 360, 370 may have its own breakdown voltage.

The TVS device 360 may include a substrate 364, a base layer 362, and an enhancement layer 366. The substrate 364 may have a polarity of the second type, e.g., P-type. The substrate 364 may be formed between the base layer 362 and the enhancement base layer 366. The base layer 362 may have a polarity of the first type, e.g., N-type. The enhancement layer 366 may have a polarity of the fourth type, e.g., P+-type. The base layer 362 may form a P-N junction 365 with the substrate 364. The TVS device 360 may be a unidirectional device.

The TVS device 360 may also include terminal layers 361 and 371. The first terminal layer 371 may be formed above and coupled to the base layer 362. It may also be coupled to an anode and/or a cathode terminal of the device 350. The second terminal layer 371 may be formed below the enhancement layer 366. The first and second terminal layers 361 and 371 may be manufactured from a conductive material, such as, for example, but not limited to, copper, copper alloy, silver, metallic alloys, etc., and/or any combinations thereof.

The TVS device 370 may include a substrate 374, an enhancement layer 372 and a base layer 376. The substrate 374 may have a polarity of the second type, e.g., P-type, which may be the same as the polarity of the substrate 364 of the TVS device 360. The substrate 374 may be formed between the enhancement layer 372 and the base layer 376. The enhancement layer 372 may have a polarity of the fourth type, e.g., P+-type. The base layer 376 may have a polarity of the first type, e.g., N-type. The base layer 376 may form a P-N junction 377 with the substrate 374. The TVS device 370 may be a unidirectional device. The TVS device 370 may also include terminal layers 363 and 373. The first terminal layer 373 may be formed above and coupled to the enhancement layer 372. The second terminal layer 363 may be formed below the base layer 376 and may also be coupled to an anode and/or a cathode terminal of the device 350.

Similar to the device 300 shown in FIG. 3a, a conductive solder 369 may be used to couple the TVS devices 360 and 370 to form the semiconductor device 350 and allow conductivity of current between TVS devices 360 and 370.

Similar to the semiconductor device 300, the semiconductor device 350 may include various dopant materials concentrations in the layer(s) 362-366, 372-376 may be uniform and/or non-uniform. This may allow for varying characteristics of the TVS device 350. Each layer(s) 362-366, 372-376 may also have its own predetermined thickness. The thicknesses of the layer(s) 362 and 366 may be less than the thickness of the substrate 364 and the thicknesses of the layer(s) 372 and 376 may be less than the thickness of the substrate 374. As can be understood, any other types of doping and/or any other thicknesses of layer(s) 362-366, 372-376 (and/or any other components of the TVS device 350) are possible.

During operation, the TVS devices 360 and 370 may be configured to clamp voltage from different directions. For example, the TVS device 360 may be configured to clamp voltage when terminal 363 is reverse biased with respect to terminal 361. The TVS device 370 may be configured to clamp voltage when terminal 361 is reverse biased with respect to terminal 363. This may allow for bidirectional asymmetric nature of the semiconductor device 300.

FIG. 4a illustrates another exemplary bidirectional asymmetric TVS device 400a, according to the current subject matter. The TVS device 400a may include a first TVS device 430a ("TVS1") and a second TVS device 440a ("TVS2") that may be coupled to the TVS device 430a using solder 409a and/or any other binding material/method. A polarity diagram 410a is illustrated to next to the TVS device 400a showing polarity of each device 430a, 440a using black triangles. Each TVS device 430a, 440a may have its own breakdown voltage.

Similar to the semiconductor devices discussed herein, the TVS device 430a may include a substrate 404a, a base layer 402a, and an enhancement layer 406a. The substrate 404a may have a polarity of the first type, e.g., N-type. The substrate 404a may be formed between the base layer 402a and the enhancement layer 406a. The base layer 402a may have a polarity of the second type, e.g., P-type. The enhancement layer 406a may have a polarity of the third type, e.g., N+-type. The base layer 402a may form a P-N junction 405a with the substrate 404a. The TVS device 430a may be a unidirectional device. The TVS device 430a may also include terminal layers 401a and 411a. The first terminal layer 411a may be formed above and coupled to the base layer 402a. It may also be coupled to an anode and/or a cathode terminal of the device 400a. The second terminal layer 411a may be formed below the enhancement layer 406a.

The TVS device 440a may include a substrate 414a, a first base layer 412a and a second base layer 416a. The substrate 414a may have a polarity of the first type, e.g., N-type. The substrate 414a may be formed between the first base layer 412a and the second base layer 416a. The first base layer 412a may have a polarity of the second type, e.g., P-type. The second base layer 416a may have a polarity of the second, e.g., P-type. The first base layer 412a may form a P-N junction 415a with the substrate 414a. The second base layer 416a may form a P-N junction 417a with the substrate 414a.The TVS device 440a may be a symmetric bidirectional device. The TVS device 440a may also include terminal layers 403a and 413a. The first terminal layer 413a may be formed above and coupled to the first base layer 412a. The second terminal layer 403a may be formed below the second base layer 416a and may also be coupled to a cathode terminal of the device 400a. The terminal layers of devices 430a and 440a may be manufactured from a conductive material, such as, for example, but not limited to, copper, copper alloy, silver, metallic alloys, etc., and/or any combinations thereof. The terminals to which the terminal layers 401a and 403a may be coupled, respectively, may be used for coupling the device 400a to one or more electronic components (e.g., printed circuit board, etc.).

The solder 409a may be used to couple the TVS devices 430a and 440a to form the semiconductor device 400a. The solder may be a conductive solder and thereby, allow conductivity of current between TVS devices 430a and 440a. The solder 409a may be manufactured from any desired conductive material, such as, for example, but not limited to, copper, copper alloy, silver, metallic alloys, etc., and/or any combinations thereof.

Each layer(s) 402a-406a, 412a-416a may also have its own predetermined thickness and/or doping concentration. The thicknesses of the layer(s) 402a and 406a may be less than the thickness of the substrate 404a and the thicknesses of the layer(s) 412a and 416a may be less than the thickness of the substrate 414a. As can be understood, any other types of doping and/or any other thicknesses of layer(s) 402a-406a, 412a-416a (and/or any other components of the TVS device 400a) are possible.

During operation, the TVS devices 430a and 440a may be configured to clamp voltage from different directions. For example, the TVS device 430a may be configured to clamp voltage when terminal 403a is forward biased with respect to terminal 401a. The TVS device 440a may be configured to clamp voltage regardless of biasing of terminal 401a.

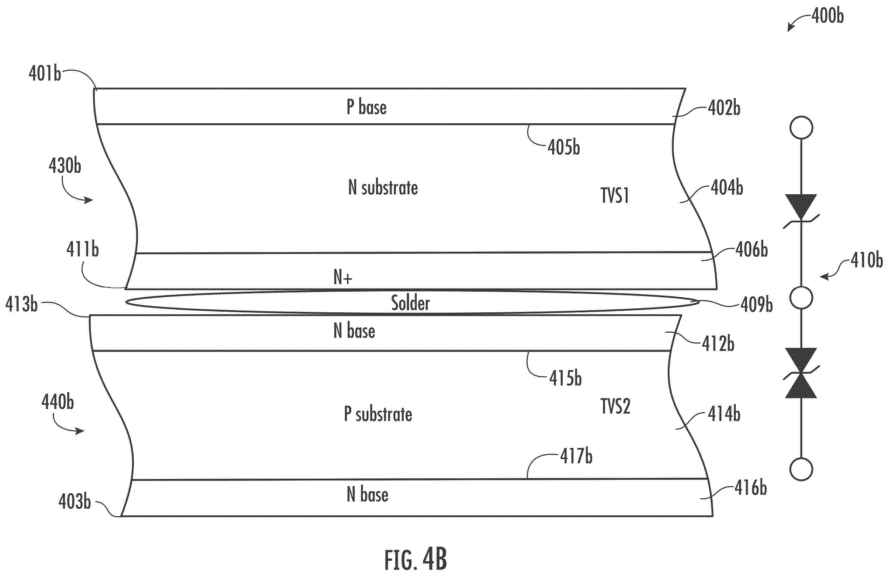

FIG. 4b illustrates another exemplary bidirectional asymmetric TVS device 400b, according to the current subject matter. The TVS device 400b may include a first TVS device 430b ("TVS1") and a second TVS device 440b ("TVS2") that may be coupled to the TVS device 430b using solder 409b and/or any other binding material/method. A polarity diagram 410b is illustrated to next to the TVS device 400b showing polarity of each device 430b, 440b using black triangles. Each TVS device 430b, 440b may have its own breakdown voltage.

Similar to the semiconductor devices discussed herein, the TVS device 430b may include a substrate 404b, a base layer 402b, and an enhancement layer 406b. The substrate 404b may have a polarity of the first type, e.g., N-type. The substrate 404b may be formed between the base layer 402b and the enhancement layer 406b. The base layer 402b may have a polarity of the second type, e.g., P-type. The enhancement layer 406b may have a polarity of the third type, e.g., N+-type. The base layer 402b may form a P-N junction 405b with the substrate 404b. The TVS device 430b may be a unidirectional device. The TVS device 430b may also include terminal layers 401b and 411b. The first terminal layer 411b may be formed above and coupled to the base layer 402b. It may also be coupled to an anode and/or a cathode terminal of the device 400b. The second terminal layer 411b may be formed below the enhancement layer 406b.

The TVS device 440b may include a substrate 414b, a first base layer 412b and a second base layer 416b. The substrate 414b may have a polarity of the second type, e.g., P-type. The substrate 414b may be formed between the first base layer 412b and the second base layer 416b. The first base layer 412b may have a polarity of the first type, e.g., N-type. The second base layer 416b may have a polarity of the first type, e.g., N-type. The first base layer 412b may form a P-N junction 415b with the substrate 414b. The second base layer 416b may form a P-N junction 417b with the substrate 414b. The TVS device 440b may be a symmetric bidirectional device. The TVS device 440b may also include terminal layers 403b and 413b. The first terminal layer 413b may be formed above and coupled to the first base layer 412b. The second terminal layer 403b may be formed below the second base layer 416b and may also be coupled to an anode and/or a cathode terminal of the device 400b. The terminal layers of devices 430b and 440b may be manufactured from a conductive material, such as, for example, but not limited to, copper, copper alloy, silver, metallic alloys, etc., and/or any combinations thereof. The terminals to which the terminal layers 401b and 403b may be coupled, respectively, may be used for coupling the device 400b to one or more electronic components (e.g., printed circuit board, etc.).

The solder 409b may be used to couple the TVS devices 430b and 440b to form the semiconductor device 400b and may be similar to the solder 409a. Similar to the device 400a shown in FIG. 4a, each layer(s) 402b-406b, 412b-416b may also have its own predetermined thickness and/or doping concentration.

The TVS device 400b may be configured to perform voltage clamping similar to the TVS device 400a shown in FIG. 4a.

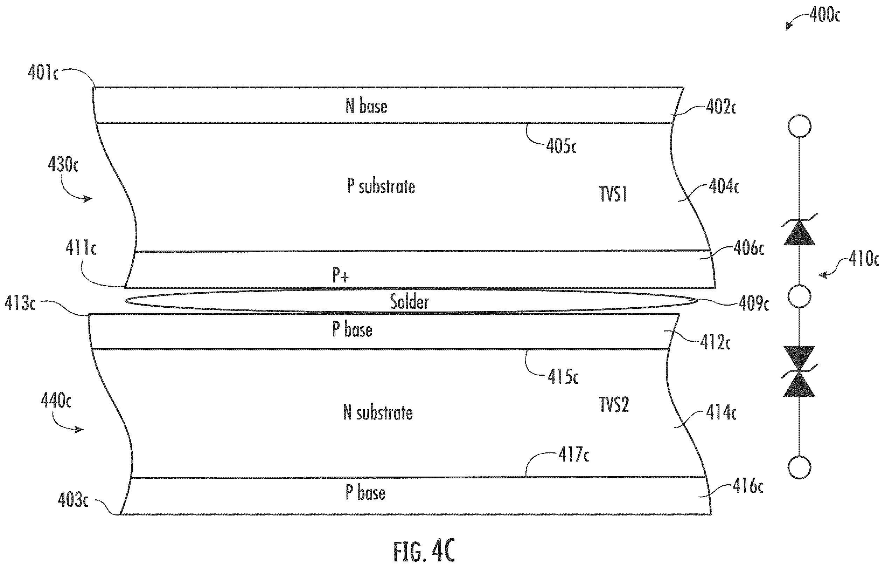

FIG. 4c illustrates another exemplary bidirectional asymmetric TVS device 400c, according to the current subject matter. The TVS device 400c may include a first TVS device 430c ("TVS1") and a second TVS device 440c ("TVS2") that may be coupled to the TVS device 430c using solder 409c (similar to solder 409a and 409b) and/or any other binding material/method. A polarity diagram 410c is illustrated to next to the TVS device 400c showing polarity of each device 430c, 440c using black triangles. Each TVS device 430c, 440c may have its own breakdown voltage.

Similar to the semiconductor devices discussed herein, the TVS device 430c may include a substrate 404c, a base layer 402c, and an enhancement layer 406c. The substrate 404c may have a polarity of the second type, e.g., P-type. The substrate 404c may be formed between the base layer 402c and the enhancement layer 406c. The base layer 402c may have a polarity of the first type, e.g., N-type. The enhancement layer 406c may have a polarity of the fourth type, e.g., P+-type. The base layer 402c may form a P-N junction 405c with the substrate 404c. The TVS device 430c may be a unidirectional device. The TVS device 430c may also include terminal layers 401c and 411c. The first terminal layer 411c may be formed above and coupled to the base layer 402c. It may also be coupled to an anode and/or a cathode terminal of the device 400c. The second terminal layer 411c may be formed below the enhancement layer 406c.

The TVS device 440c may include a substrate 414c, a first base layer 412c and a second base layer 416c. The substrate 414c may have a polarity of the first type, e.g., N-type. The substrate 414c may be formed between the first base layer 412c and the second base layer 416c. The first base layer 412c may have a polarity of the second type, e.g., P-type. The second base layer 416c may have a polarity of the second type, e.g., P-type. The first base layer 412c may form a P-N junction 415c with the substrate 414c. The second base layer 416c may form a P-N junction 417c with the substrate 414c. The TVS device 440c may be a symmetric bidirectional device. The TVS device 440c may also include terminal layers 403c and 413c. The first terminal layer 413c may be formed above and coupled to the first base layer 412c. The second terminal layer 403c may be formed below the second base layer 416c and may also be coupled to an anode and/or a cathode terminal of the device 400c. The terminal layers of devices 430c and 440c may be manufactured from a conductive material, such as, for example, but not limited to, copper, copper alloy, silver, metallic alloys, etc., and/or any combinations thereof. The terminals to which the terminal layers 401c and 403c may be coupled, respectively, may be used for coupling the device 400c to one or more electronic components (e.g., printed circuit board, etc.).

During operation, the TVS device 400c may be configured to operate oppositely to the TVS device 400b shown in FIG. 4b.

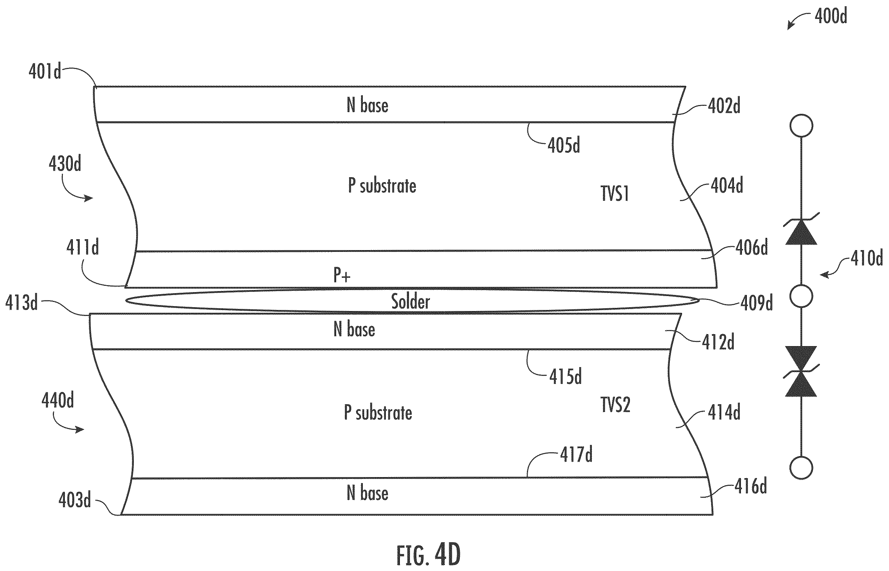

FIG. 4d illustrates another exemplary bidirectional asymmetric TVS device 400d, according to the current subject matter. The TVS device 400d may include a first TVS device 430d ("TVS1") and a second TVS device 440d ("TVS2") that may be coupled to the TVS device 430d using solder 409d (similar to solder 409a, 409b, 409c) and/or any other binding material/method. A polarity diagram 410d is illustrated to next to the TVS device 400d showing polarity of each device 430d, 440d using black triangles. Each TVS device 430d, 440d may have its own breakdown voltage.

Similar to the semiconductor devices discussed herein, the TVS device 430d may include a substrate 404d, a base layer 402d, and an enhancement layer 406d. The substrate 404d may have a polarity of the second type, e.g., P-type. The substrate 404d may be formed between the base layer 402d and the enhancement layer 406d. The base layer 402d may have a polarity of the first type, e.g., N-type. The enhancement layer 406d may have a polarity of the fourth type, e.g., P+-type. The base layer 402d may form a P-N junction 405d with the substrate 404d. The TVS device 430d may be a unidirectional device. The TVS device 430d may also include terminal layers 401d and 411d. The first terminal layer 411d may be formed above and coupled to the base layer 402d. It may also be coupled to an anode and/or a cathode terminal of the device 400d. The second terminal layer 411d may be formed below the enhancement layer 406d.

The TVS device 440d may include a substrate 414d, a first base layer 412d and a second base layer 416d. The substrate 414d may have a polarity of the second type, e.g., P-type. The substrate 414d may be formed between the first base layer 412d and the second base layer 416d. The first base layer 412d may have a polarity of the first type, e.g., N-type. The second base layer 416d may have a polarity of the first type, e.g., N-type. The first base layer 412d may form a P-N junction 415d with the substrate 414d. The second base layer 416d may form a P-N junction 417d with the substrate 414d.The TVS device 440d may be a symmetric bidirectional device. The TVS device 440d may also include terminal layers 403d and 413d. The first terminal layer 413d may be formed above and coupled to the first base layer 412d. The second terminal layer 403d may be formed below the second base layer 416d and may also be coupled to an anode and/or a cathode terminal of the device 400d. The terminal layers of devices 430d and 440d may be manufactured from a conductive material, such as, for example, but not limited to, copper, copper alloy, silver, metallic alloys, etc., and/or any combinations thereof. The terminals to which the terminal layers 401d and 403d may be coupled, respectively, may be used for coupling the device 400d to one or more electronic components (e.g., printed circuit board, etc.).

The TVS device 400d may be configured to operate similar to the TVS device 400c shown in FIG. 4c.

The semiconductor devices illustrated and described in connection with FIGS. 2a-4d are provided herein for example, non-limiting purposes only. As can be understood, any other combinations of TVS devices are possible. Each TVS device forming the semiconductor device may be a unidirectional device and/or bidirectional device, where any combination of such may be possible (e.g., unidirectional-unidirectional TVS devices combination, unidirectional-bidirectional TVS devices combination, bidirectional-unidirectional TVS devices combination, bidirectional-bidirectional TVS devices combination, etc.). Each TVS device forming the semiconductor device may have substrate have any desired polarity as well as base and/or enhancement layers having any desired polarities. Each semiconductor device and/or its respective constituting TVS devices may be characterized by specific parameters, e.g., polarities of each of the layers and/or substrates, layer(s) thickness(es), doping concentration(s) of one or more layers, breakdown voltage(s), clamping voltage(s), current(s), direction(s) of current(s), etc. Moreover, multiple (e.g., more than two) TVS devices may be coupled together to form a multi-stacked semiconductor device.

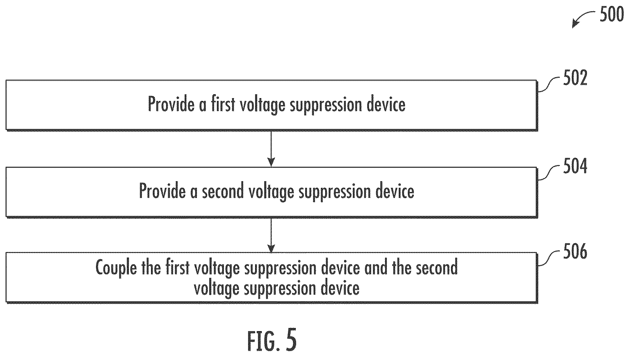

FIG. 5 illustrates an exemplary process 500 for manufacturing a transient voltage suppressor device, according to the current subject matter. The process 500 may be used to manufacture, for example, TVS devices shown in FIGS. 2a-4d.

At 502, a first voltage suppression device may be provided, the first device may include a substrate, a first layer, and a second layer. For example, the substrate may be the substrate(s) 204, 304, 364, 404a-d; the first layer may be one or more of layers 202, 302, 362, 402a-d; and the second layer may be one or more of layers 206, 306, 366, 406a-d. The substrate may be a N-type and/or P-type substrate. The first layer may be a P-base, N-base layer(s) and the second layer may be N+-base, P+-base layer(s). The substrate may be coupled to the first layer on one side. The substrate may also be coupled to the second layer on an opposite side, as for example shown in FIGS. 2a-4d. The coupling of the substrate and the first layer may be configured to form a first junction and the coupling of the substrate (alternatively, or in addition, no junction is formed). Similarly, the second layer may be configured to form a second junction (alternatively, or in addition, no junction is formed). The first voltage suppression device may be a TVS device (e.g., TVS device 230, 330, 360, 430a-d).

At 504, a second voltage suppression device may be provided. The second voltage suppression device may include a substrate (e.g., substrate 214, 314, 374, 414a-d), a first layer (e.g., layer(s) 212, 312, 372, 412a-d) and a second layer (e.g., layer(s) 216, 316, 376, 416a-d). The substrate may be formed between the first and second layers. The substrate may be an N- type and/or P-type substrate; the first and second layers may be P-type, P+ type, N-type, N+-type layers. The first layer may form a first junction with the substrate (alternatively, or in addition, no junction is formed). The second layer may form a second junction with the substrate (alternatively, or in addition, no junction is formed). The second voltage suppression device may be a TVS device (e.g., device(s) 240, 340, 370, 442a-d).

At 506, the first voltage suppression device may be coupled to the second voltage suppression device. The first voltage suppression device may also be coupled to an anode and/or a cathode terminal of the transient voltage suppression device and the second voltage suppression device may be coupled to an anode and/or a cathode terminal of the transient voltage suppression device.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example. Accordingly, division, omission or inclusion of block functions depicted in the accompanying figures does not infer that the hardware components, circuits, software and/or elements for implementing these functions would necessarily be divided, omitted, or included.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together for the purpose of streamlining the disclosure. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are openended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

## Claims

1. A transient voltage suppression system, comprising:
a first voltage suppression device having a first voltage suppression device substrate, a first voltage suppression device first layer, and a first voltage suppression device second layer, the first voltage suppression device substrate is coupled to the first voltage suppression device first layer, and is coupled to the first voltage suppression device second layer;
a second voltage suppression device having a second voltage suppression device substrate, a second voltage suppression device first layer and a second voltage suppression device second layer, the second voltage suppression device substrate is coupled to the second voltage suppression device first layer and is coupled to the second voltage suppression device second layer; and
wherein the first voltage suppression device is coupled to the second voltage suppression device.

2. The transient voltage suppression system according to claim 1, wherein the first voltage suppression device substrate and the second voltage suppression device substrate are at least one of: a N-type substrate or a P-type substrate.

3. The transient voltage suppression system according to claim 1 or 2, wherein
the first voltage suppression device first layer and the second voltage suppression device first layer are at least one of: a N-type layer or a P-type layer; and
the first voltage suppression device second base layer and the second voltage suppression device second layer are at least one of: a N-type layer, a P-type layer, a N+-type layer, or a P+-type layer.

4. The transient voltage suppression system according to any of the preceding claims, wherein the first voltage suppression device first layer is P-type layer, the first voltage suppression device substrate is N-type substrate, and the first voltage suppression device second layer is N+-type layer.

5. The transient voltage suppression system according to any of the claims 1-3, wherein the first voltage suppression device first layer is N-type layer, the first voltage suppression device substrate is P-type substrate, and the first voltage suppression device second layer is P+-type layer.

6. The transient voltage suppression system according to any of the preceding claims, wherein the second voltage suppression device first layer is N+-type layer, the second voltage suppression device substrate is N-type substrate, and the second voltage suppression device second layer is P-type layer.

7. The transient voltage suppression system according to any of the claims 1-5, wherein the second voltage suppression device first layer is P+-type layer, the second voltage suppression device substrate is P-type substrate, and the second voltage suppression device second layer is N-type layer.

8. The transient voltage suppression system according to any of the claims 1-5, wherein the second voltage suppression device first layer is P-type layer, the second voltage suppression device substrate is N-type substrate, and the second voltage suppression device second layer is P-type layer.

9. The transient voltage suppression system according to any of the claims 1-5, wherein the second voltage suppression device first layer is N-type layer, the second voltage suppression device substrate is P-type substrate, and the second voltage suppression device second layer is N-type layer.

10. The transient voltage suppression system according to any of the preceding claims, further comprising one or more terminals coupled to one or more of the first and second layers of the first and second voltage suppression devices, wherein the transient voltage suppression device is **characterized by** a clamping voltage, wherein the clamping voltage is determined based on biasing of the one or more terminals,
and/or
wherein each of the first and second voltage suppression devices is **characterized by** a respective breakdown voltage.

11. The transient voltage suppression system according to any of the preceding claims, wherein the first voltage suppression device is at least one of: a unidirectional transient voltage suppression device or a bidirectional transient voltage suppression device,
and/or
wherein the second voltage suppression device is at least one of: a unidirectional transient voltage suppression device or a bidirectional transient voltage suppression device.

12. The transient voltage suppression system according to any of the preceding claims, wherein the transient voltage suppression system is an asymmetric transient voltage suppression system.

13. The transient voltage suppression system according to any of the preceding claims, wherein the first voltage suppression device is coupled to the second voltage suppression device using a conductive solder, preferably wherein the conductive solder couples the second layer of the first voltage suppression device and the first layer of the second voltage suppression device.

14. The transient voltage suppression device according to claim 1, wherein the first voltage suppression device first layer is coupled to an anode or a cathode termination layer, and the second voltage suppression device second layer is coupled to another anode or another cathode termination layer.

15. A method, comprising:
providing a first voltage suppression device having a first voltage suppression device substrate, a first voltage suppression device first layer, and a first voltage suppression device second layer, the first voltage suppression device substrate coupled to the first voltage suppression device first layer, and coupled to the first voltage suppression device second layer;
providing a second voltage suppression device having a second voltage suppression device substrate, a second voltage suppression device first layer and a second voltage suppression device second layer, the second voltage suppression device substrate being coupled to the second voltage suppression device first layer and being coupled to the second voltage suppression device second layer; and
coupling the first voltage suppression device to the second voltage suppression device.
